# EUROPEAN PATENT APPLICATION

(11) **EP 4 779 483 A1**
(43) Date of publication of application: **22.07.2026**
(21) Application number: 25220539.8
(22) Date of filing: 03.12.2025
(51) Int. Cl.: G06F 13/16, G11C 5/04, G11C 7/10

(54) **METHODS AND APPARATUS FOR PSEUDO-SPLIT DIE MEMORY ACCESS**

(30) Priority: 20.01.2025 US 202563747280 P; 24.09.2025 US 202519338886
(71) Applicant: INTEL Corporation, Santa Clara, CA 95054 (US)
(72) Inventor: HINCK, Todd Andrew, Arlington, MA (US); GOLES, John R., Folsom, CA (US); ALAMEER, Hussein, Portland, OR (US); SETHURAMAN, Saravanan, Portland, OR (US)
(74) Representative: Rummler, Felix

(57) **Abstract**

Systems, apparatus, articles of manufacture, and methods are disclosed. An example memory module includes: a memory die a first pseudo-split die having first interface circuitry; and a second pseudo-split die having second interface circuitry; and a multiplexer external to the memory die, the multiplexer having a first port connected to the first interface circuitry, a second port connected to the second interface circuitry, and a third port connected to memory controller circuitry.

## Description

### RELATED APPLICATION

This patent claims the benefit of U.S. Provisional Patent Application No. 63/747,280, which was filed on January 20, 2025. U.S. Provisional Patent Application No. 63/747,280 is hereby incorporated herein by reference in its entirety. Priority to U.S. Provisional Patent Application No. 63/747,280 is hereby claimed.

### BACKGROUND

In recent years, demand for increases in storage space and memory speeds has increased. Industry members have developed and modified various architectures to meet these increased demands. Two such architectures are Dual In-Line Memory Module (DIMM) and Double Data Rate (DDR).

### BRIEF DESCRIPTION OF THE DRAWINGS

FIG. 1 is a block diagram of a compute device constructed in accordance with the teachings of this disclosure.
FIG. 2 is a block diagram of a first example implementation of the Double Data Rate 7 (DDR6) Dual In-line Memory Module (DIMM) circuitry of FIG. 1.
FIG. 3 is a block diagram of a second example implementation of the DDR6 DIMM circuitry.
FIG. 4 shows block diagrams of a first and second example implementation of a DRAM package.
FIG. 5 is a timing diagram illustrating the example performance of the Time Division Multiple Access (TDMA) circuitry of FIG. 2.
FIG. 6 is a flowchart representative of example machine readable instructions and/or example operations that may be executed, instantiated, and/or performed by example programmable circuitry to implement the TDMA circuitry of FIG. 2.
FIG. 7 is a block diagram of an example processing platform including programmable circuitry structured to execute, instantiate, and/or perform the example machine readable instructions and/or perform the example operations of FIG. 6 to implement the DDR6 DIMM circuitry 102 of FIG. 2.

In general, the same reference numbers will be used throughout the drawing(s) and accompanying written description to refer to the same or like parts. The figures are not necessarily to scale.

### DETAILED DESCRIPTION

DIMM is employed in a circuit board architecture in which multiple memory dies are implemented. DIMM circuit boards connect to a motherboard through a double sided pin connection (e.g., the front side of a pin and the back side of a pin are electrically isolated from one another so that a first set of memory dies connect to the motherboard through the front side of the pin and a second set of memory dies connect through the back side of the pin). DIMM enables faster throughput than legacy architectures such as single in-line memory modules (SIMM).

DDR memory generally conforms to a series of standards published by JEDEC (Joint Electron Device Engineering Council, now the JEDEC Solid State Technology Association) in which data is transferred on both the rising and falling edges of a clock signal. As a result, DDR memory enables faster data rates and increased bandwidth than legacy architectures such as Single Data Rate (SDR). A dual in line memory module (DIMM) that employs Double Data Rate (DDR) protocols is referred to as DDR DIMM.

Industry members have developed multiple generations of DIMM and DDR architectures. In July 2020 JEDEC published the fifth version of DDR (DDR5). DDR5 introduced Multiplex Combined Rank (MCR) in which data from two different dies within two different ranks on a DIMM circuit board are multiplexed together. As used in the foregoing and herein, "rank" refers to a collection of memory dies on a DIMM that correspond to their relative position on the circuit board. For example, a rank of memory dies may be physically implemented in sequential order on a DDR DIMM and collectively form a row on the circuit board. While MCR increases the bandwidth compared to previous versions of DDR, the architecture requires wiring between two separate dies on two different ranks to a third area on the circuit board where the multiplexing occurs. Such extensive wiring can increase both the design complexity of the integrated circuit, the fabrication complexity, and the cost of such devices. Furthermore, because ranks implemented near one another on a DIMM circuit board share a bus, a penalty in the form of idle cycles occurs in DDR5 when the multiplexer switches between ranks. DDR5 additionally requires the use of a single Command and Address (CA) channel to support both dies in the DDR5 version of MCR. CA data intended for a first die and CA data intended for a second die must therefore share the single CA channel through interleaving, which reduces the bandwidth dedicated to each die.

JEDEC is currently developing the sixth version of DDR (DDR6) which introduces pseudo-split dies. As used herein, a pseudo-split die refers to a logical portion of a physical die that has its own interface circuitry and can operate independently from other logical portions within the same physical die. Example methods, apparatus, and systems described herein introduce a new architecture for DDR6 in which data from pseudo-split dies within the same physical die package travel through separate interface circuitry, exit the die as independent data streams, and then are multiplexed together. As a result, examples described herein multiplex data streams without the rank-switching penalty that DDR5 occurs, thereby improving performance. Because wiring is only needed between a given multiplexer and a single physical die to combine data streams in examples described herein, the wiring reduces cost and design complexity compared to the wiring in known DDR5 architectures. Examples described herein may additionally reduce the length of wiring, thereby improving performance compared to DDR5. Furthermore, in some examples, each pseudo-split die includes interface circuitry to support its own CA signal, thereby removing the need to perform CA data interleaving that is present in DDR5.

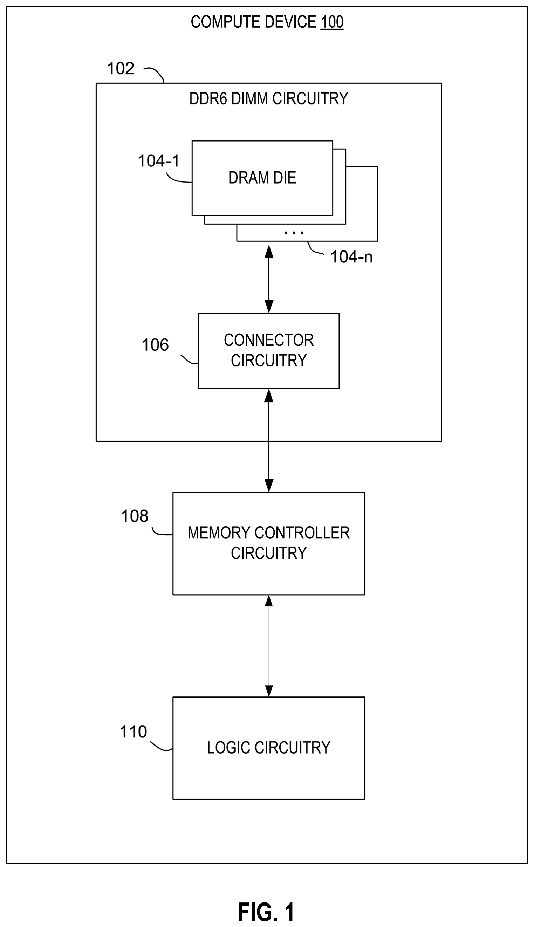

FIG. 1 is a block diagram of an example compute device 100 constructed in accordance with the teachings of this disclosure. The compute device 100 includes example DDR6 DIMM circuitry 102, example memory controller circuitry 108, and example logic circuitry 110. The DDR6 DIMM circuitry 102 includes example Dynamic Random Access Memory (DRAM) dies 104-1, 104-2, ..., 104-n (collectively referred to as DRAM dies 104), and example connector circuitry 106.

The DDR6 DIMM circuitry 102 provides memory resources to the compute device 100. In this example, the memory resources are the DRAM dies 104. In other examples, the memory resources of the DDR6 DIMM circuitry 102 are implemented by one or more different types of memory. In this example, the DDR6 DIMM circuitry 102 is implemented on a daughterboard that interfaces with the rest of the compute device 100 by connecting to a motherboard. The DDR6 DIMM circuitry 102 is compliant with at least the DDR6 and DIMM architectures and may be additionally compliant with other memory architectures.

Each of the DRAM dies 104 of this example is implemented by a physical die. As used herein, the terms "memory die" and "physical die" refers to an individual chip that has its own integrated circuit and packaging. Thus, the DDR6 DIMM circuitry 102 includes n separate and independent memory chips. In contrast, the term pseudo-split die as used herein refers to a logical portion of a physical die and its corresponding circuitry. Accordingly, a single physical die may contain multiple pseudo-split dies.

The connector circuitry 106 facilitates the exchange of data and other support signals between the DRAM dies 104 and the rest of the compute device 100. The connector circuitry 106 of this example performs multiplexing between pseudo-split dies that belong to the same physical die in accordance with the teachings of this disclosure.

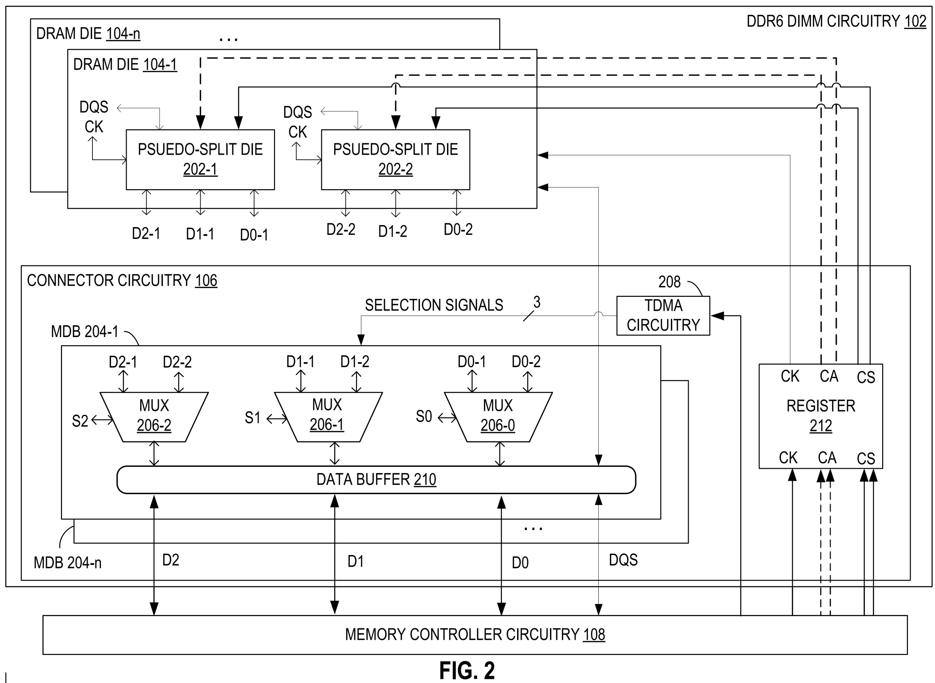

The connector circuitry 106 may be programmable or may be non-programmable dedicated circuitry. In programmable examples, the connector circuitry 106 may include any type of programmable circuitry. Examples of programmable circuitry include but are not limited to programmable microprocessors, Field Programmable Gate Arrays (FPGAs) that may instantiate instructions, Central Processor Units (CPUs), Graphics Processor Units (GPUs), Digital Signal Processors (DSPs), XPUs, or microcontrollers and integrated circuits such as Application Specific Integrated Circuits (ASICs). An example implementation of the connector circuitry 106 is described further in connection with FIG. 2.

The memory controller circuitry 108 manages the flow of data between the logic circuitry 110 and the DDR6 DIMM circuitry 102. The memory controller circuitry 108 may perform operations including, but not limited to, memory refreshing and memory addressing to manage the flow of data. In the example of FIG. 1, the memory controller circuitry 108 is implemented externally from the DDR6 DIMM circuitry 102. Accordingly, in FIG. 1, the memory controller circuitry 108 may additionally manage the flow of data between the logic circuitry 110 and other memory resources on the compute device 100. In other examples, the DDR6 DIMM circuitry 102 is implemented on the DDR6 DIMM circuitry 102 and is only responsible for the memory resources on that daughterboard. In some examples, the memory controller circuitry 108 is referred to as controller circuitry.

The logic circuitry 110 refers to a computational resource on the compute device 100 that reads data from and/or writes data to the DDR6 DIMM circuitry 102. The data accessed and/or generated by the logic circuitry 110 may correspond to any task. The logic circuitry 110 may be implemented by any type of programmable circuitry.

FIG. 2 is a block diagram of an example implementation of the DDR6 DIMM circuitry 102 of FIG. 1. The DDR6 DIMM circuitry 102 of FIG. 2 may be instantiated (e.g., creating an instance of, bring into being for any length of time, materialize, implement, etc.) by programmable circuitry. For example, programmable circuitry may be implemented by a Central Processor Unit (CPU) executing first instructions, a field programmable gate array, a programmable logic device (PLD), a generic array logic (GAL) device, a programmable array logic (PAL) device, a complex programmable logic device (CPLD), a simple programmable logic device (SPLD), a microcontroller (MCU), a programmable system on chip (PSoC), etc. Additionally or alternatively, the DDR6 DIMM circuitry 102 of FIG. 2 may be instantiated (e.g., creating an instance of, bring into being for any length of time, materialize, implement, etc.) by (i) an Application Specific Integrated Circuit (ASIC) and/or (ii) a Field Programmable Gate Array (FPGA) (e.g., another form of programmable circuitry) structured and/or configured in response to execution of second instructions to perform operations corresponding to the first instructions. It should be understood that some or all of the circuitry of FIG. 2 may, thus, be instantiated at the same or different times. Some or all of the circuitry of FIG. 2 may be instantiated, for example, in one or more threads executing concurrently on hardware and/or in series on hardware. Moreover, in some examples, some or all of the circuitry of FIG. 2 may be implemented by microprocessor circuitry executing instructions and/or FPGA circuitry performing operations to implement one or more virtual machines and/or containers.

The DDR6 DIMM circuitry 102 of FIG. 2 includes the DRAM dies 104 and the connector circuitry 106 as described in FIG. 1. FIG. 2 shows that a given DRAM die 104-1 includes example pseudo-split dies (PSDs) 202-1 and 202-2. FIG. 2 also shows that the connector circuitry 106 includes example Multiplexed Data Buffers (MDBs) 204-1, 204-2, ... 204-n (collectively referred to as MDBs 204), an example register 212, and example Time Division Multiple Access (TDMA) circuitry 208. A given MDB 204-1 includes example multiplexers (MUXs) 206-0, 206-1, and 206-2 (collectively referred to as MUXs 206), and an example data buffer 210.

Within the DRAM dies 104, the PSDs 202 represent a portion of the computational resources within a physical die. In this example, each DRAM die 104-1 contains two PSDs 202 and each PSDs 202 contains approximately 60% of the computational resources within the physical die. More generally, a given DRAM die 104-1 may contain any number of PSDs 202, and a given PSD may contain any proportion of the computational resources within the physical die. Notably, each of the PSDs 202 include their own interface circuitry in FIG. 2. In this example, the interface circuitry within a given PSD (e.g., 202-1) includes at least three data ports (labeled D2, D1, and D0), a Command Address port, and a Chip Selection port as described further below. In other examples, the interface circuitry for a given PSD includes a different number and/or different type of ports. In some examples, a port may be referred to as a terminal, a pin, etc. In some examples, a PSD 202-1 may be referred to as a logical portion of a physical die because the interface circuitry allow the memory controller circuitry 108 to communicate with the PSD 202-1 independently from the other PSDs in the physical die.

In this example, the connector circuitry 106 includes one MDB 204 for each DRAM die 104. Within a given MDB (e.g., 204-1), a given MUX (e.g., 206-0) includes one port that is connected to one PSD (e.g., 202-1) from a DRAM die (e.g., 104-1) and one port that is connected to a different PSD (e.g., 202-2) from the same DRAM die (e.g., 104-2). In the example of FIG. 2, a given MDB 20-1 includes three MUXs 206 to support the three data streams D2, D1, and D0 supported by each of the PSDs 202. In other examples, a given MDB 204-1 contains a different number of MUXs based on the number of PSDs 202 per physical DRAM die 104 and the number of data streams supported per PSD. As used herein, the terms "data stream" and "data channel" and "signal" may be used interchangeably.

In this example, the MUXs 206 are bi-directional multiplexers that facilitate the exchange of data between the PSDs 202 and a data buffer 210. In other examples, the connector circuitry 106 includes one set of uni-directional MUXs for read operations and a separate set of uni-directional MUXs for write operations. When reading data from a DRAM die 104-1, a given MUX 206-0 determines whether to pass data from the PSD 202-1 or 202-2 to the memory controller circuitry 108 based on a selection signal (which are labelled S0, S1, and S2 in FIG. 2) provided by the TDMA circuitry 208. Similarly, writing data to the DRAM die 104-1, the MUX 206-0 determines whether to store data in the PSD 202-1 or 202-2 based on a selection signal provided by the TDMA circuitry 208. The TDMA circuitry 208 generates one selection signal per MUX 206. Therefore, in this example, the TDMA circuitry 208 generates a total of 3n selection signals for the 3n MUXs 206 implemented within the connector circuitry 106.

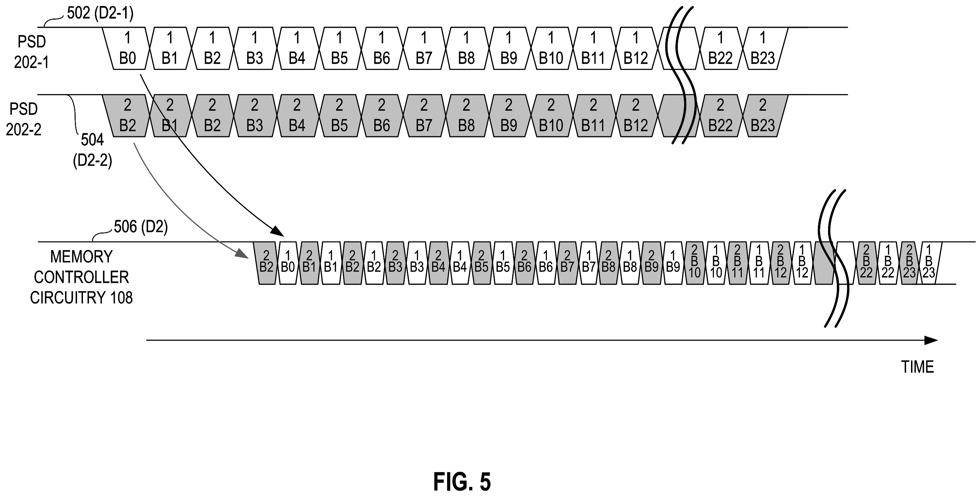

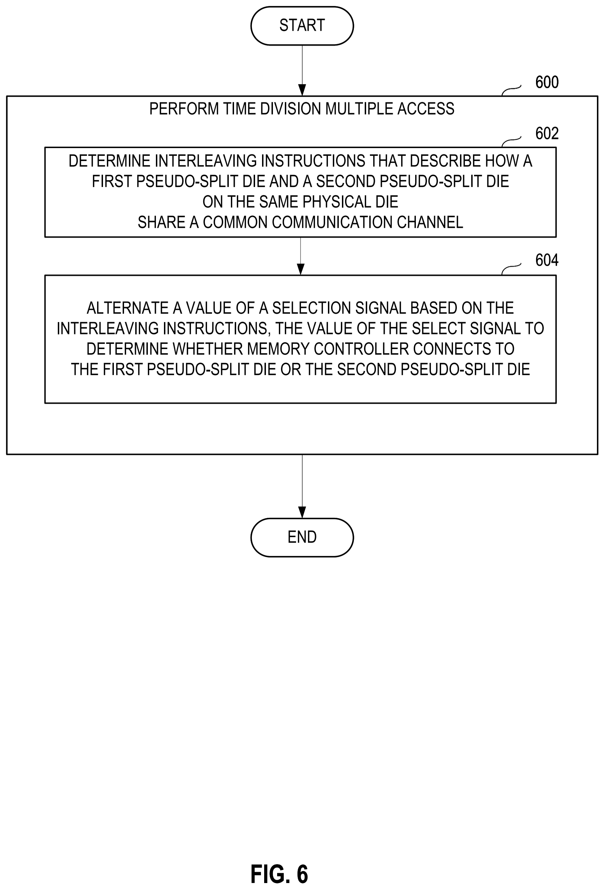

The TDMA circuitry 208 generates the selection signals so that when the compute device 100 performs a read operation, a given MUX (e.g. 206-0) interleaves data (e.g., D0-1 and D0-2) from two PSDs 202 on the same physical die DRAM die 104-1 into a shared stream of data (e.g., D0) that is provided to the memory controller circuitry 108. Interleaving is described further in connection with the example of FIG. 5. Similarly, the TDMA circuitry 208 generates the selection signals so that when the compute device 100 performs a write operation, a given MUX e.g., (206-0) receives a data stream that contains data for two separate PSDs and distributes individual datums (e.g., bytes) from the stream to the correct destination (e.g., one of PSD 202-1 or 202-2). In some examples, the TDMA circuitry 208 is instantiated by programmable circuitry executing TDMA instructions and/or configured to perform operations such as those represented by the flowchart of FIG. 6. In some examples, the TDMA circuitry 208 is referred to as controller circuitry.

The data buffer 210 include an amount of memory to temporarily store data before being transferred to one of the PSDs 202 or the memory controller circuitry 108. The temporary storage enables the PSDs 202 and the memory controller circuitry 108 to communicate with one another despite, in some examples, having different data transfer rates. The data buffer 210 may include a First In First Out (FIFO) queue for data transferred in write operations and a second FIFO queue for data transferred in read operations. In this example, the connector circuitry 106 includes one data buffer 210 per MDB 204. More generally, the connector circuitry 106 may have a different number of data buffers (one total, one per MUX, etc.) where the amount of memory in a given data buffer is based on the number of ports connected to the data buffer.

The MDBs 204 also enable the exchange of bidirectional data strobe (DQS) signals between the memory controller circuitry 108 and the DRAM dies 104-1. The PSDs 202 use the DQS signals to synchronize data transmission and capture, thereby ensuring read and write operations occur at the correct time and preventing errors due to timing skews. In this example, a given MDB (e.g., 204-1) provides one DQS signal per DRAM die (e.g., 104-1) that is shared by the PSDs on said DRAM die.

The register 212 is an amount of memory within the connector circuitry 106 that supports the transfer of the clock (CK), the Command and Address (CA), and the Chip Select (CS) signals from the memory controller circuitry 108 to the DRAM dies 104. The register 212 enables the DRAM dies 104 and the memory controller circuitry 108 to communicate with one another despite, in some examples, having different data transfer rates.

The PSDs 202 use the CK signal (e.g., a pulse wave with a fixed frequency) as a reference to perform various operations. In this example, a given MDB (e.g., 204-1) provides one CK signal per DRAM die (e.g., 104-1) that is shared by the PSDs on said DRAM die.

The memory controller circuitry 108 uses the CA signals provide command and address information to the PSDs 202. In general, the command and address information describes which operation to perform (e.g., read, write, refresh) and where in memory to access. In the examples described herein, the memory controller circuitry 108 generates, and the register 212 provides, one CA signal per PSD. Thus, FIG. 2 includes a total of 2*n* CA signals.

The memory controller circuitry 108 uses the CS signals to enable one of the PSDs (e.g., 202-1) and disable the other PSD(s) (e.g., 202-2) within a physical die. The memory controller circuitry 108 then communicates exclusively with the enables PSD over a communication channel (e.g., an interconnect, a wire, a bus, etc.) that is shared by the multiple PSDs. For example, within the DRAM die 104-1, the memory controller circuitry 108 enables the PSD 202-1 and disables the PSD 202-2 to indicate data on the DQS signal is only intended for the PSD 202-1. In this example, the memory controller circuitry 108 generates, and the register 212 provides, one CS signal per PSD for a total of 2*n* in FIG. 2.

While an example manner of implementing the DDR6 DIMM circuitry 102 of FIG. 1 is illustrated in FIG. 2, one or more of the elements, processes, and/or devices illustrated in FIG. 2 may be combined, divided, re-arranged, omitted, eliminated, and/or implemented in any other way. Further, the TDMA circuitry 208, and/or, more generally, the example DDR6 DIMM circuitry 102 of FIG. 2, may be implemented by hardware alone or by hardware in combination with software and/or firmware. Thus, for example, the TDMA circuitry 208, and/or, more generally, the example DDR6 DIMM circuitry 102, could be implemented by programmable circuitry, processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), vision processing units (VPUs), and/or field programmable logic device(s) (FPLD(s)) such as FPGAs in combination with machine readable instructions (e.g., firmware or software). Further still, the example DDR6 DIMM circuitry 102 of FIG. 2 may include one or more elements, processes, and/or devices in addition to, or instead of, those illustrated in FIG. 2, and/or may include more than one of any or all of the illustrated elements, processes and devices.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

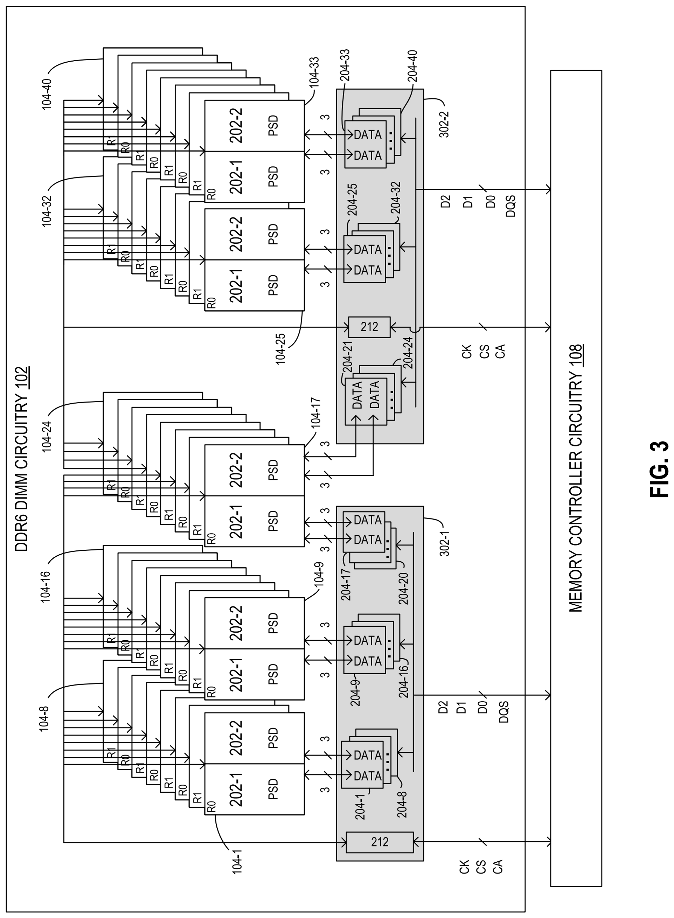

FIG. 3 is a block diagram of a second example implementation of the DDR6 DIMM circuitry 102. In FIG. 3, the DDR6 DIMM circuitry 102 includes example DRAM dies 104-1, 104-2, ..., 104-40 and example connector dies 302-1 and 302-2.

FIG. 3 is an example implementation of FIG. 2 where n = 50. Thus, in FIG. 3, there are forty physical dies that each contain two PSDs 202 for a total of eighty PSDs 202. Similarly, there are forty MDBs 204 in the example of FIG. 3 so that, as shown in FIG. 2, each MDB supports the exchange of three data signals (D2, D1, D0) between the memory controller circuitry 108 and two PSDs within the same physical die.

In the example of FIG. 3, the DRAM dies 104 are organized into five groups where each group contains eight dies that are physically stacked above one another in three-dimensional space. For example, DRAM die 104-1 is implemented above DRAM die 104-2, which is implemented above DRAM die 104-3, ..., which is implemented above DRAM die 104-8. In some examples, DRAM dies 104-1, 104-9, 104-17, 104-25, and 104-33 may be referred to as the top of their respective stacks, while DRAM dies 104-8, 104-16, 104-24, 104-32, and 104-40 may be referred to as bottom of their respective stacks. In other examples, the DRAM dies 104 are organized into a different number of stacks and/or the DDR6 DIMM circuitry 102 includes a different number of DRAM dies 104. In some examples, the relative position of a DRAM die 104-1 within three-dimensional space compared to another DRAM die 104-2 is referred to as the height or the depth of the DRAM die 104-1.

In FIG. 3, the position of DRAM dies 104 within their respective stacks correspond to the rank of a given physical die. For example, DRAM dies 104-1, 104-9, 104-17, 104-25, and 104-33 (which are all at the top of their respective stack) correspond to the same rank, DRAM dies 104-2, 104-10, 104-18, 104-26, and 104-34 (which are all one die below the top in their respective stack) correspond to the same rank, etc. Accordingly, if DDR5 techniques were used to implement MCR in the circuitry of FIG. 3, wiring would need to connect a single multiplexer to two different heights within the stacks because each of eight ranks in FIG. 3 are implemented at different heights. Advantageously, in the examples described herein, the wiring of FIG. 3 connects a single multiplexer to a single DRAM die 104 at a single height, thereby reducing the length and/or complexity of wiring compared to DDR5. The wiring described in examples described herein also avoids the rank switching penalty suffered by known DDR5 architectures.

In the example of FIG. 3, DDR6 DIMM circuitry 102 includes two connector dies 302-1 and 302-2 that collectively implement the connector circuitry 106 of FIGS. 1 and 2. The connector dies 302-1 and 302-2 are two separate physical dies that each include a register 212 and twenty MDBs 204 that support 2.5 stacks of DRAM dies 104. Thus, data and control signals for the third stack of DRAM dies 104 (which include DRAM dies 104-17 through 104-24) is exchanged with the memory controller circuitry 108 through both the connector dies 302-1 and 302-2. In this example, the connector die 302-1 supports DRAM dies 104-17 through 104-20 (the top half of a stack) and the connector die 302-2 supports DRAM dies 104-21 through 104-24 (the bottom half of the stack). In other examples, the connector circuitry 106 is implemented by a different number of physical dies.

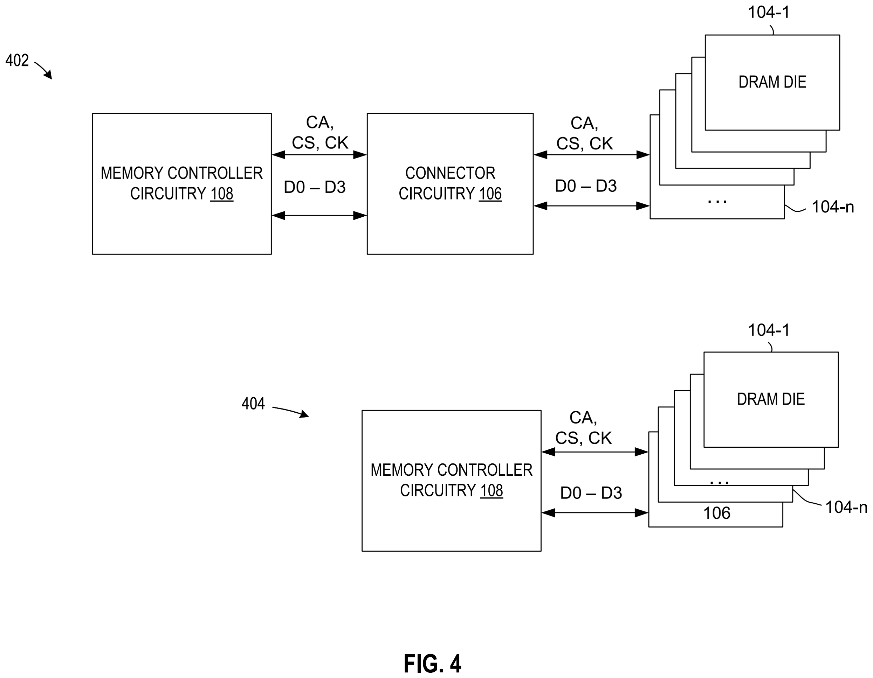

FIG. 4 shows a block diagram of example implementations 402 and 404 of the compute device 100. In the implementation 402, the connector circuitry 106 is located externally from the one or more IC packages that contains the three dimensional stack of DRAM dies 104. In contrast, the one or more instances of the connector circuitry 106 in the implementation 404 are part of the three dimensional stack, located below the DRAM dies 104 and within the corresponding IC packages. The connector circuitry 106 of the implementation 404 may exchange command and data signals with the DRAM dies 104 above it using 3D Through-Silicon Via (3DTSV) technology or a wire bond.

FIG. 5 is a timing diagram illustrating the example performance of the TDMA circuitry of FIG. 2. FIG. 5 includes example signals 502, 504, and 506. The signal 502 is a data stream produced by the PSD 202-1 (e.g., D2-1 as shown in FIG. 2) of the DRAM die 104-1 during a write operation. In this example, the data stream from the signal 502 is a series of bytes labelled 1 B0, 1 B1, etc. The signal 502 shows that the interface circuitry within the PSD 202-1 transfers the sequence of bytes at a first data rate.

Similarly, the signal 504 is a corresponding data stream produced by the PSD 202-2 (e.g., D2-2 as shown in FIG. 2) of the same DRAM die 104-1 during a write operation. In this example, the data stream from the signal 504 is a series of bytes labelled 2 B0, 2 B1, etc. The signal 504 shows that the interface circuitry within the PSD 202-2 transfers the sequence of bytes at a second data rate. In this example, the first data rate and the second data rate are equal. In other examples, the PSDs 202 within the same physical die have different data rates from one another.

During a write operation, the MUX 210-2 receives the signals 502 and 504 as inputs and generates the signal 506 as an output. The signal 506 is a combined data stream (e.g., D2) that is provided to the memory controller circuitry 108 during the write operation. The contents of the signal 506 at any point in time are dependent on the configuration of the MUX 210-2. As used in this example, a configuration of the MUX 210-2 refers to whether the output port of the MUX 210-2 is connected to its first input (where the signal 502 is provided) or its second input port (where the signal 504 is provided). The configuration of the MUX 210-2 is determined by S2, the selection signal generated by the TDMA circuitry 208 as described in FIG. 2.

In the example of FIG. 5, the signal 506 shows that the TDMA circuitry 208 generates the S2 signal so that the configuration of the MUX 210-2 changes every time one of the bytes from a data stream is transmitted across the output port (e.g., the first byte in the signal 506 corresponds to the signal 502, the second byte corresponds to the signal 504, the third byte corresponds to the signal 502, etc.) Accordingly, the data streams from signals 502 and 504 alternate within the combined data stream of signal 506. In some examples, the alternating combination of two data stream signals shown in FIG. 5 is referred to as interleaving. More generally, the operations performed by the TDMA circuitry 208 may be referred to as Time Division Multiple Access operations (TDMA) because they result in two PSDs 202 from the same physical die (e.g., the DRAM die 104-1) sharing a common signal (e.g., 506) by dividing the signal into time slots. Advantageously, the data rate of the signal 506 is larger than the first data rate from the signal 502 and the second data rate from the signal 504. Thus, the retrieval rate of data from first interface circuitry from the PSD 202-1 is a fraction of a total retrieval rate of the memory die 104-1.

FIG. 6 is a flowchart representative of example machine readable instructions and/or example operations 600 that may be executed, instantiated, and/or performed by programmable circuitry to perform time division multiple access (TDMA). The example machine-readable instructions and/or the example operations 600 of FIG. 6 begin when the TDMA circuitry 208 determines interleaving instructions that describe how a first PSD 202-1 and a second PSD 202-2 on the same physical die share a common communication channel. (Block 602). The interleaving instructions may assign portions of the total bandwidth of the shared communication channel to the respective PSDs 202. For example, both PSDs 202 contribute approximately one half of the total bandwidth of the signal 506 in FIG. 5. More generally, a given PSD may be assigned any portion of the total bandwidth of the shared communication channel.

In some examples, the TDMA circuitry 208 determines one or more of the interleaving instructions based on the performance characteristics of the DDR6 DIMM circuitry 102. The TDMA circuitry 208 may additionally or alternatively receive one or more of the interleaving instructions from the memory controller circuitry 108. In some examples, the TDMA circuitry 208 uses the same interleaving instructions for each separate data stream supported by a given PSD. In other examples, the TDMA circuitry 208 uses separate interleaving instructions for one or more of the separate data streams supported by a given PSD.

The TDMA circuitry 208 alternates a value of a selection signal based on the interleaving instructions, the value of the selection signal to determine whether the memory controller circuitry 108 connects to the first PSD 202-1 or the second PSD 202-2. (Block 604). The alternating selection signal changes the configuration of a MUX 206, which in turn combines and interleaves a data stream from the PSD 202-1 and the PSD 202-2 into the shared communication channel. The TDMA circuitry 208 can therefore cause transmission of data across the shared communication channel at a total data rate that is the sum of the data rates from the two PSDs 202.

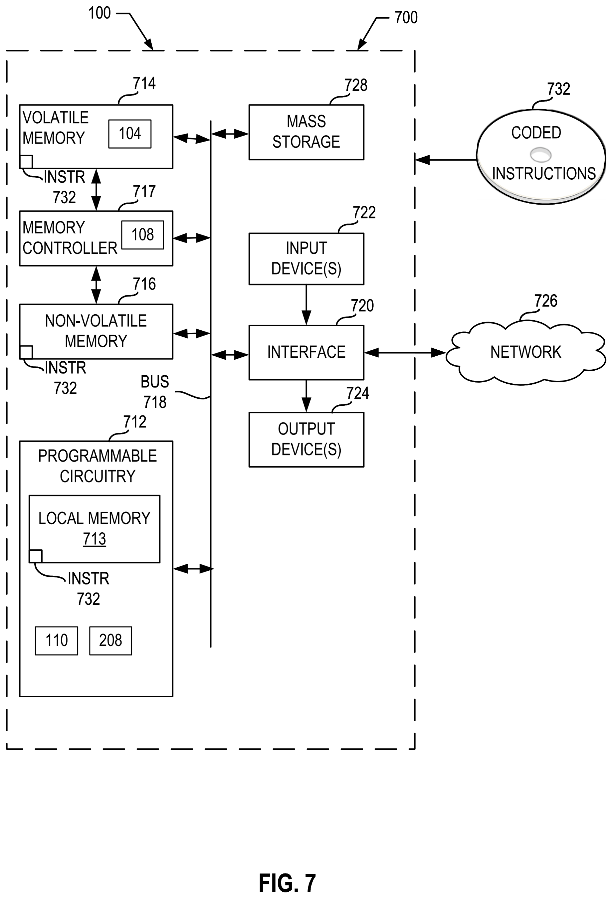

FIG. 7 is a block diagram of an example programmable circuitry platform 700 structured to execute and/or instantiate the example machine-readable instructions and/or the example operations of FIG. 6 to implement the compute device 100 of FIG. 1. The programmable circuitry platform 700 can be, for example, a server, a personal computer, a workstation, a self-learning machine (e.g., a neural network), a mobile device (e.g., a cell phone, a smart phone, a tablet such as an iPad^{™}), a personal digital assistant (PDA), an Internet appliance, a DVD player, a CD player, a digital video recorder, a Blu-ray player, a gaming console, a personal video recorder, a set top box, a headset (e.g., an augmented reality (AR) headset, a virtual reality (VR) headset, etc.) or other wearable device, or any other type of computing and/or electronic device.

The programmable circuitry platform 700 of the illustrated example includes programmable circuitry 712. The programmable circuitry 712 of the illustrated example is hardware. For example, the programmable circuitry 712 can be implemented by one or more integrated circuits, logic circuits, FPGAs, microprocessors, CPUs, GPUs, VPUs, DSPs, and/or microcontrollers from any desired family or manufacturer. The programmable circuitry 712 may be implemented by one or more semiconductor based (e.g., silicon based) devices. In this example, the programmable circuitry 712 implements at least the logic circuitry 110 and the TDMA circuitry 208.

The programmable circuitry 712 of the illustrated example includes a local memory 713 (e.g., a cache, registers, etc.). The programmable circuitry 712 of the illustrated example is in communication with main memory 714, 716, which includes a volatile memory 714 and a non-volatile memory 716, by a bus 718. The volatile memory 714 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 716 may be implemented by flash memory and/or any other desired type of memory device. Access to the main memory 714, 716 of the illustrated example is controlled by a memory controller 717. In some examples, the memory controller 717 may be implemented by one or more integrated circuits, logic circuits, microcontrollers from any desired family or manufacturer, or any other type of circuitry to manage the flow of data going to and from the main memory 714, 716. In this example, the memory controller 717 is implemented by at least the memory controller circuitry 108 and may additionally implement one or more components of the connector circuitry 106. In this example, the volatile memory 714 is implemented by at least the DRAM dies 104.

The programmable circuitry platform 700 of the illustrated example also includes interface circuitry 720. The interface circuitry 720 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 722 are connected to the interface circuitry 720. The input device(s) 722 permit(s) a user (e.g., a human user, a machine user, etc.) to enter data and/or commands into the programmable circuitry 712. The input device(s) 722 can be implemented by, for example, an audio sensor, a microphone, a camera (still or video), a keyboard, a button, a mouse, a touchscreen, a trackpad, a trackball, an isopoint device, and/or a voice recognition system.

One or more output devices 724 are also connected to the interface circuitry 720 of the illustrated example. The output device(s) 724 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 720 of the illustrated example, thus, typically includes a graphics driver card, a graphics driver chip, and/or graphics processor circuitry such as a GPU.

The interface circuitry 720 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 726. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 700 of the illustrated example also includes one or more mass storage discs or devices 728 to store firmware, software, and/or data. Examples of such mass storage discs or devices 728 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs.

The machine readable instructions 732, which may be implemented by the machine readable instructions of FIG. 6, may be stored in the mass storage device 728, in the volatile memory 714, in the non-volatile memory 716, and/or on at least one non-transitory computer readable storage medium such as a CD or DVD which may be removable.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

Example methods, apparatus, systems, and articles of manufacture for pseudo-split die memory access are disclosed herein. Further examples and combinations thereof include the following:
Example 1 includes a memory module comprising a memory die including a first pseudo-split die having first interface circuitry, and a second pseudo-split die having second interface circuitry, and a multiplexer external to the memory die, the multiplexer having a first port connected to the first interface circuitry, a second port connected to the second interface circuitry, and a third port connected to memory controller circuitry.
Example 2 includes the memory module of example 1, wherein the first pseudo-split die is a first logical portion of the memory die and the second pseudo-split die is a second logical portion of the memory die.
Example 3 includes the memory module of one or more of examples 1 and 2, wherein the first interface circuitry is to receive data independently from the second interface circuitry.
Example 4 includes the memory module of example 3, wherein a data rate of data from the first interface circuitry is a fraction of a total data rate of the memory die.
Example 5 includes the memory module of example 4, wherein the fraction is approximately one half.
Example 6 includes the memory module of one or more of examples 1 - 5, wherein the first interface circuitry includes a first data port connected to the multiplexer, a first command address port, and a first chip selection port, and the second interface circuitry includes a second data port connected to the multiplexer, a second command address port, and a second chip selection port.
Example 7 includes the memory module of one or more of examples 1 - 6, wherein the first interface circuitry includes a first port to receive a first Command and Address (CA) signal from the memory controller circuitry, and the second interface circuitry includes a second port to receive a second Command and Address (CA) signal from the memory controller circuitry, the first CA signal different from the second CA signal.
Example 8 includes a system comprising a multiplexer, a memory die including a first pseudo-split die having first interface circuitry, and a second pseudo-split die having second interface circuitry, and controller circuitry to instruct the multiplexer to combine a first data stream from the first pseudo-split die and a second data stream from the second pseudo-split die into one communication channel.
Example 9 includes the system of example 8, wherein the multiplexer is to perform time division multiple access to combine the first data stream and the second data stream.
Example 10 includes the system of one or more of examples 8 and 9, wherein multiplexer is to interleave the first data stream and the second data stream into the communication channel.
Example 11 includes the system of one or more of examples 8 - 10, wherein the first data stream has a first data rate, the second data stream has a second data rate, and the controller circuitry is to cause transmission of data across the communication channel at a third data rate that is larger than the first data rate or the second data rate.
Example 12 includes the system of example 11, wherein the third data rate is a sum of the first data rate and the second data rate.
Example 13 includes the system of examples 8 - 12, wherein the memory die is a first memory die, the communication channel is a first communication channel, and the multiplexer is to combine a first data stream from a first pseudo-split die of a second memory die and a second data stream from a second pseudo-split die of the second memory die into a second communication channel.
Example 14 includes the system of example 13, wherein the first memory die is above the second memory die in three-dimensional space.
Example 15 includes the system of example 13, wherein the second memory die and the first memory die are part of a dual in-line memory module.
Example 16 includes a method comprising multiplexing a first data stream from a first pseudo-split die within a memory die and a second data stream from a second pseudo-split die within the memory die into a combined data stream, and causing transmission of the combined data stream via a shared communication channel to controller circuitry.
Example 17 includes the method of example 16, wherein the multiplexing includes performing time division multiple access with the first data stream and the second data stream.
Example 18 includes the method of one or more of examples 16 - 17, wherein the multiplexing includes interleaving the first data stream and the second data stream.
Example 19 includes the method of one or more of examples 16 - 18, wherein the first data stream has a first data rate, the second data stream has a second data rate, and the method includes transmitting data across the shared communication channel at a third data rate that is larger than the first data rate or the second data rate.
Example 20 includes the method of example 19, wherein the third data rate is a sum of the first data rate and the second data rate.
Example 21 includes a non-transitory machine readable storage medium comprising instructions to cause programmable circuitry to at least multiplex a first data stream from a first pseudo-split die within a memory die and a second data stream from a second pseudo-split die within the memory die into a combined data stream, and cause transmission of the combined data stream via a shared communication channel to controller circuitry.
Example 22 includes the non-transitory machine readable storage medium of example 21, wherein to multiplex the first and second data streams the programmable circuitry is to perform time division multiple access with the first data stream and the second data stream.
Example 23 includes the non-transitory machine readable storage medium of one or more of examples 21 and 22, wherein to multiplex the first and second data streams the programmable circuitry is to interleave the first data stream and the second data stream.
Example 24 includes the non-transitory machine readable storage medium of one or more of examples 21 - 23, wherein the first data stream has a first data rate, the second data stream has a second data rate, and the programmable circuitry is to transmit data across the shared communication channel at a third data rate that is larger than the first data rate or the second data rate.
Example 25 includes the non-transitory machine readable storage medium of example 24, wherein the third data rate is a sum of the first data rate and the second data rate.

From the foregoing, it will be appreciated that example systems, apparatus, articles of manufacture, and methods have been disclosed for pseudo-split die memory access. Disclosed systems, apparatus, articles of manufacture, and methods improve the efficiency of using a computing device by implementing multiplexers in which a first port of a given multiplexer is connected to a first pseudo-split die and a second port within the multiplexer is connected to a second pseudo-split die within the same physical die. This enables the multiplexer to perform TDMA and combine two independent data streams from two portions of the same physical die into a shared communication channel, thereby improving performance (e.g., reducing wiring length and complexity, avoiding rank switch penalties, etc.) compared to known approaches. Disclosed systems, apparatus, articles of manufacture, and methods are accordingly directed to one or more improvement(s) in the operation of a machine such as a computer or other electronic and/or mechanical device.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A memory module comprising:
a memory die including:
a first pseudo-split die having first interface circuitry; and
a second pseudo-split die having second interface circuitry; and
a multiplexer external to the memory die, the multiplexer having a first port connected to the first interface circuitry, a second port connected to the second interface circuitry, and a third port connected to memory controller circuitry.

2. The memory module of claim 1, wherein the first pseudo-split die is a first logical portion of the memory die and the second pseudo-split die is a second logical portion of the memory die.

3. The memory module of one or more of claims 1 - 2, wherein the first interface circuitry is to receive data independently from the second interface circuitry.

4. The memory module of claim 3, wherein a data rate of data from the first interface circuitry is a fraction of a total data rate of the
memory die.

5. The memory module of claim 4, wherein the fraction is approximately one half.

6. The memory module of claim 1, wherein:
the first interface circuitry includes a first data port connected to the multiplexer, a first command address port, and a first chip selection port; and
the second interface circuitry includes a second data port connected to the multiplexer, a second command address port, and a second chip selection port.

7. The memory module of one or more of claims 1, 2, or 3, wherein:
the first interface circuitry includes a first port to receive a first Command and Address (CA) signal from the memory controller circuitry; and
the second interface circuitry includes a second port to receive a second Command and Address (CA) signal from the memory controller circuitry, the first CA signal different from the second CA signal.

8. A system comprising:
a multiplexer;
a memory die including:
a first pseudo-split die having first interface circuitry; and
a second pseudo-split die having second interface circuitry; and
controller circuitry to instruct the multiplexer to combine a first data stream from the first pseudo-split die and a second data stream from the second pseudo-split die into one communication channel.

9. The system of claim 8, wherein the multiplexer is to perform time division multiple access to combine the first data stream and the second data stream.

10. The system of one or more of claims 8 or 9, wherein multiplexer is to interleave the first data stream and the second data stream into the communication channel.

11. The system of one or more of claims 8 - 10, wherein:
the first data stream has a first data rate;
the second data stream has a second data rate; and
the controller circuitry is to cause transmission of data across the communication channel at a third data rate that is larger than the first data rate or the second data rate.

12. The system of claim 11, wherein the third data rate is a sum of the first data rate and the second data rate.

13. The system of one or more of claims 8 - 11, wherein:
the memory die is a first memory die;
the communication channel is a first communication channel; and
the multiplexer is to combine a first data stream from a first pseudo-split die of a second memory die and a second data stream from a second pseudo-split die of the second memory die into a second communication channel.

14. The system of claim 13, wherein the first memory die is above the second memory die in three-dimensional space.

15. The system of claim 13, wherein the second memory die and the first memory die are part of a dual in-line memory module.
